# EUROPEAN PATENT APPLICATION

(11) **EP 0 597 100 A1**
(43) Date of publication of application: **18.05.1994**
(21) Application number: 92914442.6
(22) Date of filing: 02.07.1992
(51) Int. Cl.: G03F 7/32

(54) **DEVELOPING SOLUTION AND DEVELOPING METHOD**

(30) Priority: 02.07.1991 JP 188149/91
(71) Applicant: OHMI, Tadahiro, Sendai-shi Miyagi-ken 980 (JP)
(72) Inventor: OHMI, Tadahiro, Sendai-shi Miyagi-ken 980 (JP)
(74) Representative: Weitzel, Wolfgang, Dr.-Ing. Patentanwalt
(86) International application number: JP9200840
(87) International publication number: WO9301527

(57) **Abstract**

To provide a developing solution and a developing method, by which an ultrafine pattern of a photoresist can be formed in a high yield and the components of the developing solution remaining on a wafer can be thouroughly removed by washing with ultrapure water after the development. The developing solution is one to be used in preparing a photoresist and comprises a surfactant and an aqueous alkali solution, which is characterized in that it contains H₂0₂, that the aqueous alkali solution is an aqueous solution of tetramethylammonium hydroxide (TMAH) or one mainly comprising TMAH, and that the molecular weight of the surfactant is 500 to 5,000. The developing method is characterized by using a developing solution for preparing a photoresist comprising a surfactant and an aqueous alkali solution and containing H₂0₂ to pattern a photoresist on a substrate.

## Description

### Technological Field

The present invention relates to a resist developing solution used in lithography, and in greater detail, relates to a resist developing solution and developing method for use in ultrafine pattern formation employed in ultra LSI production processes.

### Background Art

The conventional technology will be explained using semiconductor manufacturing processes as an example.

In LSI manufacturing processes, as a result of the progress of the shift to highly integrated elements and the shift to large diameter wafers, lithography processes have come to be regarded as more important.

In lithography processes, after a photoresist is applied by spin coating, a prespecified pattern is exposed by means of a mask, and development is carried out by means of a developing solution, and thereby, a resist pattern having a prespecified shape is formed. Positive resist is commonly used as a resist for ultrafine patterns, and alkali developing solution is used as the developing solution.

Here, as the pattern form has become more ultrafine as a result of the shift to high integration, it has become difficult to wet the resist with the developing solution, and resist which should be removed remains in the pattern, and the like, so that undesirable variations in pattern formation occur, and it has become difficult to form ultrafine patterns with a high yield. In particular, in the case of wafers with a diameter of 8 inches, it is extremely difficult to form a resist pattern over the entire wafer surface without undesirable variation. Furthermore, when the developing solution is brought into contact with the silicon wafer surface, as the solution is alkaline, the silicon is etched, and very small irregularities are generated on the wafer surface. Furthermore, a problem exists in that even if an oxide film is formed on the wafer, the thin oxide film which is required for ultra LSI is completely or partially dissolved by the developing solution, and the silicon is etched, as described above. The present inventors have solved the above problem by the addition of an appropriate surfactant to the developing solution, and it has thus become possible to form an ultrafine resist pattern with good yield on large diameter wafers of 8 inches or more.

However, in the course of further research, it has become apparent that the above surfactant is adsorbed by the silicon surface, and cannot be removed even by rinse washing with ultrapure water, so that the characteristics of the elements ultimately worsen. The present inventors have invented a method in which a silicon wafer having formed thereon a resist pattern after developing is immersed in a 30% H₂0₂ solution into which Pt (for example, a mesh) has been placed, as a method for removing the surfactant adsorbed on a wafer.

By means of a method in which a wafer is immersed in a Pt/H₂0₂ solution after developing, it is possible to completely remove the surfactant adsorbed by the silicon, and it thus becomes possible to develop high performance devices. This method is an extremely superior method for the removal of surfactant; however, a procedure in which the wafer is immersed in a H₂0₂ tank into which Pt is placed is added, and thus the lithography process becomes more complicated, and furthermore, there are problems with the degradation of the H₂0₂ and the corrosion of the wafer conveyance system. In addition, there are cases in which the resist pattern is also degraded, and furthermore, over long periods of use, there are problems with adhesion of the Pt particles to the silicon wafer, and with a deterioration of the lifetime characteristics of the elements.

In light of the above circumstances, the present invention has as an object thereof to provide a developing solution and developing method which is capable of forming an ultrafine pattern of a photo resist with a high yield, and which is capable of completely removing developing solution components on a wafer by means of ultrapure water after development.

### Disclosure of the Invention

A first feature of the present invention resides in a developing solution, characterized in that in a developing solution for photo resist comprising a surfactant and an aqueous alkali solution, the developing solution contains H₂0₂.

A second feature of the present invention resides in a developing method, characterized in that using the developing solution of the first feature, a photo resist on a substrate body is subjected to patterning.

### (Function)

Hereinbelow, the function of the present invention will be explained.

The developing solution of the present invention is obtained by blending a surfactant and H₂0₂ with an alkaline developing agent. By means of this solution, a photo resist is immersed or subjected to spin development after exposure, and a resist pattern is thus formed.

The alkaline developing agent utilizes an inorganic alkali such as KOH, NaOH, or the like, or an organic alkali, such as choline, tetramethyl ammonium hydroxide (TMAH), or the like; however, if inorganic alkali remains on the wafer, it represents an extremely damaging impurity, so that the use of an organic alkali is preferable, and TMAH is preferable because of its ease of handling. In general, NWD-3, produced by Tokyo Oka Kogyo Corp., SD-1, produced by Tokuyama Sotatsu Corp., or the like, is employed.

A positive or negative novolak type resist is normally employed as the photo resist; concrete examples thereof include, for example, OFPR-800, produced by Tokyo Oka Kogyo Corp., among positive resists, and among negative resists, THMR- iN100, produced by Tokyo Oka Kogyo Corp., and the like.

It is preferable that surfactants having a molecular weight within a range of 500-5000 be employed. Surfactants having a molecular weight within this range are extremely stable, and the wettability thereof with respect to the resist is greatly improved. Furthermore, it thus becomes possible to reliably form an ultrafine pattern, as well as to suppress the further etching of the silicon as a result of the alkali developing solution. In the case of a surfactant having a low molecular weight (for example, a molecular weight in the range of 200-300), no surfactant effects are noted in the alkali solution, and this is thus not preferable for the formation of the ultrafine pattern of a high performance element. That is to say, in the alkali developing solution, a surfactant having a molecular weight of 500 or greater is necessary. Furthermore, if the molecular weight is too large, the surfactant will insufficiently dissolve in the solution, will be precipitated, and cause pattern deficiencies.

In the present invention, the above surfactant is contained in an amount of 100 ppm - 1% in the developing solution. At levels of more than 1%, foaming and the like occurs, and undesirable variation in the pattern is caused, so that it is desirable to set the range given above.

Furthermore, it is desirable that the H₂0₂ concentration should be 0.001% or more in the developing solution; in this range, the surfactant removal effect is further increased.

As explained above, by means of blending H₂0₂ into an alkali developing solution containing a surfactant, it becomes possible to completely remove surfactant on a wafer by means of rinse washing with ultrapure water, and moreover, it becomes possible to form an ultrafine pattern of a resist highly precisely and with a high yield.

### Brief Description of the Drawings

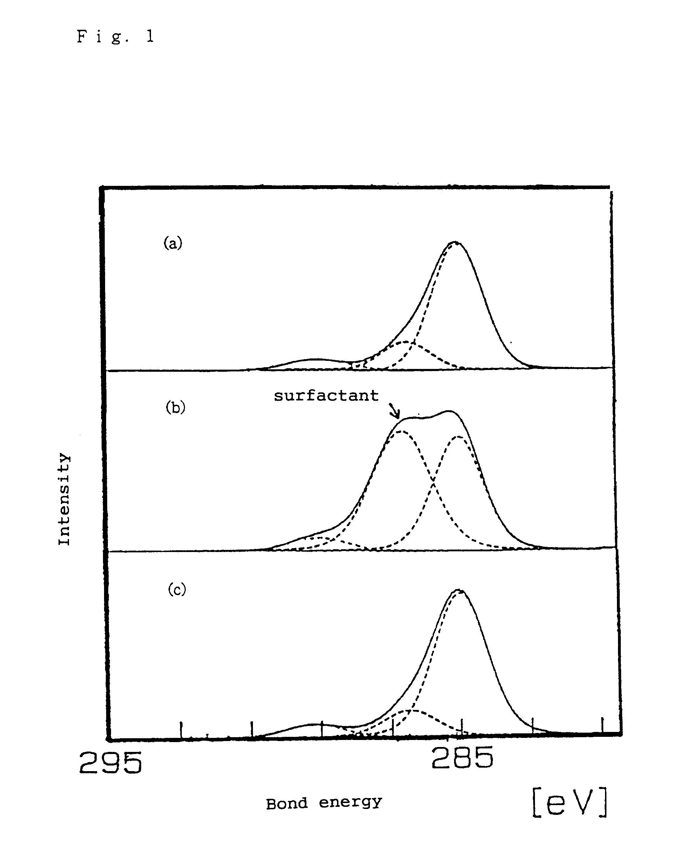

Fig. 1 is an XPS spectrograph of silicon wafer surfaces after immersion in various developing solutions and rinsing with pure water.
(a) An aqueous solution of 2.38% TMAH.
(b) An aqueous solution of 2.38% TMAH containing 250 ppm of surfactant.
(c) An aqueous solution of 2.38% TMAH containing 0.1 % H₂0₂ and 250 ppm of surfactant.

### Best Mode for Carrying Out of the Invention

Hereinbelow, the present invention will explained in detail based on embodiments.

### (Embodiment 1)

In order to demonstrate that surfactant does not remain on the surface of a silicon wafer when the developing solution of the present invention is used and after rinse washing with pure water, developing solutions of (a) an aqueous solution of 2.38% TMAH, (b) an aqueous solution of 2.38% of TMAH containing 250 ppm of surfactant (molecular weight 2000), and (c) an aqueous solution of 2.38% TMAH, containing 250 ppm of surfactant and 0.1% of H₂0₂, were prepared, the silicon wafer was immersed therein for a period of 70 seconds, and an ultrapure rinse was conducted for a period of 60 seconds. Next, the wafer was subjected to baking for 30 minutes at a temperature of 130°C, and then the surface of the silicon wafer was observed using XPS(X-ray Photoelectron Spectrometry). The results thereof are shown in Fig. 1.

As is clear from Figs. 1 (a) and (b), the XPS spectra of the wafer which was immersed in developing solution (b) containing surfactant exhibited the peak which was due to the surfactant, and this indicates that surfactant was adsorbed by the silicon wafer surface and was not removed by the pure water washing. However, as shown in Fig. 1-(c), in the case in which the developing solution (c) of the present invention, containing H₂0₂, was employed, the surfactant peak was not observed, and the spectra thereof were identical to those in the case of the developing solution of Fig. 1 (a) which contained no surfactant. This indicates that if developing solution (c) of the present envention is used, the surfactant can be removed from the surface of the silicon.

Furthermore, when the surface roughness Ra of the above silicon wafers was measured using an STM (Scanning Tunneling Microscope), it was confirmed that the developing solution (c) of the present preferred embodiment, as was the case with the developing solution (b) containing only the surfactant, prevented surface roughness to a great extent in comparison with the developing solution (a), which did not contain surfactant.

### (Embodiment 2)

Next, a 1 micrometer layer of a TSMR8900 photo resist was spin-coated onto a bare silicon wafer having a diameter of 8 inches, and this was subjected to pre-baking at a temperature of 80 _{°} C, a mask having a pattern with a width of 0.6 micrometers was interposed, and exposure was conducted. This was subjected to dipping development for a period of 70 seconds using a developing solution (the developing solution c of embodiment 1) containing 2.38% of TMAH, 0.1% of H₂0₂, and 250 ppm of surfactant (molecular weight 2000), and was then subjected to a pure water rinse for a period of 60 seconds and post-baking at a temperature of 130°C was conducted.

The resist pattern obtained in this manner was an extremely sharp 0.6 micrometer pattern covering the entire wafer which was identical to that in the case in which a developing solution containing no H₂0₂ (developing solution b of embodiment 1) was used.

### Industrial Applicability

In accordance with the present invention, it becomes possible to provide a developing solution and a developing method which, by means of adding H₂0₂ to an aqueous alkali solution containing a surfactant, is capable of forming an ultrafine pattern of a photo resist with good yield, and is capable of completely removing a surfactant by means of pure water washing.

## Claims

1. A developing solution for photo resist comprising a surfactant and an aqueous alkali solution, wherein said developing solution contains H₂0₂.

2. A developing solution in accordance with Claim 1, wherein said aqueous alkali solution comprises an aqueous solution of tetramethylammonium hydroxide (TMAH) or an aqueous solution comprising mainly TMAH.

3. A developing solution in accordance with Claims 1 and 2, wherein the molecular weight of said surfactant is within a range of 500-5000.

4. A developing method, wherein a photo resist on a substrate body is subjected to patterning using a developing solution in accordance with one of Claims 1 through 3.
